Europäisches Patentamt

European Patent Office

Office européen des brevets

(19)

(11) EP 1 481 953 A2

(12) **EUROPÄISCHE PATENTANMELDUNG**

(43) Veröffentlichungstag:
01.12.2004  Patentblatt 2004/49

(51) Int Cl.⁷: $C04B\ 35/45$, $H01L\ 39/12$, $H01L\ 39/24$

(21) Anmeldenummer: 04100638.8

(22) Anmeldetag: 18.02.2004

(84) Benannte Vertragsstaaten:
AT BE BG CH CY CZ DE DK EE ES FI FR GB GR
HU IE IT LI LU MC NL PT RO SE SI SK TR
Benannte Erstreckungsstaaten:
AL LT LV MK

(30) Priorität: 19.02.2003  DE 10307643
10.12.2003  DE 10359131

(71) Anmelder: Leibniz-Institut für Festkörper- und
Werkstoffforschung Dresden e.V.
01069 Dresden (DE)

(72) Erfinder:
• SHLYK, Larysa
01705 Freital (DE)
• KRABBES, Gernot
01809 Heidenau (DE)
• DIKO, Pavel
09353, Kosice (SK)

(74) Vertreter: Rauschenbach, Dieter
Bienertstrasse 15
01187 Dresden (DE)

(54) **Hochtemperatursupraleitender Körper und Verfahren zu dessen Herstellung**

(57)   Die Erfindung betrifft einen hochtemperatursupraleitenden Körper und ein Verfahren zu dessen Herstellung. Der Körper enthält die supraleitende Verbindung vom Typ $REMe_2Cu_3O_7$ oder besteht aus dieser und ist mit einem Schmelztexturierungsprozess hergestellt.

Erfindungsgemäß enthält der Körper zusätzlich eines oder mehrere der chemischen Elemente aus einer mit Ru, Ir, Rh, Hf, Ta und W gebildeten Gruppe A und zusätzlich eines oder mehrere der chemischen Elemente aus einer mit Zn, Li, Ni und Pd gebildeten Gruppe B. Dabei ist die molare Menge n des Zusatzes der Gruppe A je 1 Mol $REMe_2Cu_3O_7$ mit $0,01 < n < 0,3$ und die molare Menge m des Zusatzes der Gruppe B je 1 Mol $REMe_2Cu_3O_7$ mit $0,001 < m < 0,1$ gewählt. Gemäß einem weiteren Erfindungsmerkmal besteht der schmelztexturierte Körper aus einer supraleitenden Matrix, in der neben einem oder mehreren Elementen der Gruppe B noch Bereiche enthalten sind, die eines oder mehrere Elemente der Gruppe A konzentriert enthalten. Diese Bereiche liegen als elongierte Partikel, als lamellenartig ausgebildete Zonen oder als granulare Einschlüsse vor.

Der Körper kann in den verschiedensten geometrischen Formen ausgeführt sein, beispielsweise als ringförmiges Bauteil mit quadratischem oder rechteckigem Querschnitt, als kreisscheibenförmiges Bauteil, als quaderförmiges Bauteil oder als Schicht auf einer Unterlage. Derartige Bauteile können insbesondere in der Energie-, der Antriebs- und der Transporttechnik angewandt werden.

EP 1 481 953 A2

**Beschreibung**

Die Erfindung betrifft einen hochtemperatursupraleitenden Körper und ein Verfahren zu dessen Herstellung. Der Körper kann in den verschiedensten geometrischen Formen ausgeführt sein, beispielsweise als ringförmiges Bauteil mit quadratischem oder rechteckigem Querschnitt, als kreisscheibenförmiges Bauteil, als quaderförmiges Bauteil oder als Schicht auf einer Unterlage. Derartige Bauteile können insbesondere in der Energie-, der Antriebs- und der Transporttechnik angewandt werden.

Massive hochtemperatursupraleitende Materialien werden üblicherweise durch eine peritektische Schmelzkristallisation durch Umkehr der Zersetzungsreaktion

- Supraleiterphase (Massivmaterial) Schmelze + -Festphase

hergestellt, die für $YBa_2Cu_3O_7$- (YBCO) als -Phase an Luft bei 1020°C abläuft (z.B. M. Murakami et al., Journal of Engineering Materials and Technology 114(1992) 189-195). Nicht reagierte -Phase $Y_2BaCuO_5$ (211) bleibt im Fall von YBCO als Einschluss im Gefüge erhalten. Die diesem Prozess zugrunde liegende Kristallisation verbunden mit einem Temperaturgradienten wird üblicherweise als Schmelztexturierung bezeichnet.

Die wichtigsten Eigenschaften der so erhaltenen Formkörper werden durch die kritische Stromdichte bestimmt, die selbst dadurch begrenzt ist, dass der in den Supraleiter vom Typ II eindringende Magnetfluss unter dem Einfluss von Feld und Strom in Bewegung gerät (Dissipation, die bis zum Verlust der Supraleitung führen kann). Herkömmliche Massivmaterialien sind Verbundmaterialien, in denen Partikel einer Zweitphase, $Y_2BaCuO_5$, enthalten sind. Dabei wird an den inneren Grenzflächen Magnetfluss festgehalten ("pinning"). Nach dem Stand der Technik hergestellte Materialien enthalten bis zu 50 % dieser nichtsupraleitenden Phase, wodurch der stromtragende Querschnitt beträchtlich eingeengt wird. Dies wirkt sich besonders stark in beschichteten Leiterbahnen und Bändern aus, in denen die Supraleiterdicke nur einige 10 bis 100 nm beträgt.

Kürzlich wurde zwar gefunden, dass durch chemische Substitution z.B. Zn für Cu in Y123 Supraleitern (DE 101 12 990) die kritische Stromdichte deutlich vergrößert werden kann. In herkömmlichen Verfahren entsteht aber immer die nichtsupraleitende Phase $Y_2BaCuO_5$ verfahrensbedingt in beträchtlichen Anteilen. Ihr Vorhandensein ermöglicht ein tiegelfreies formstabiles peritektisches Aufschmelzen und, in der Umkehrung, die Kristallisation quasieinkristalliner Blöcke. Deshalb besteht ein dringendes Bedürfnis darin, Lösungen für den Ersatz des nichtsupraleitenden Füllmaterials zu finden, ohne dabei die Verarbeitbarkeit des Materials im Schmelzkristallisationsprozess, der ein tiegelfreies formstabiles Verfahren ist, zu beeinträchtigen.

Besonders effektive Pinnungzentren entstehen in Form lang ausgedehnter Kanäle (nm-Durchmesser) bei Bestrahlung mit energiereichen Neutronen oder energiereichen Strahlen (R. Gonzalez-Arrabal, M. Eisterer, H. W. Weber, G. Fuchs, P. Verges, G. Krabbes, Very high trapped fields in neutron irradiated and reinforced $YBa_2Cu_3O_7$- melt-textured superconductors, Applied Physics Letters, **81** 2002 (5) 868 - 870; R. Weinstein, R. -P. Sawh, D.

Parks, M. Murakami, T. Mochida, N. Chikumoto, G. Krabbes, W. Bieger, Very high values of $J_c$ obtained in $NdBa_2Cu_3O_x$ by use of U/n process Physica C **383** (2002) 214 - 222).

Wegen der nur langsam abklingenden Restaktivität sind diese Verfahren ökonomisch uneffektiv.

Eine Sonderform massiver Supraleiter stellen dicke Filme des supraleitenden Materials auf $REBa_2Cu_3O_7$-Basis dar, die für bestimmte Anwendungen in der Informationsübertragung oder Energieübertragung eine vorteilhafte Alternative zu "Powder in tube"-BiSCCO-Materialien bilden, aufgetragen auf ein Substrat, beispielsweise aus Keramik oder ein Metallband.

Nachteile bisheriger Lösungen sind hier die geringe Wachstumsgeschwindigkeit bei physikalischer Beschichtung und die mangelhafte Schichtqualität bei chemischen Verfahren. Die Kristallisation über Schmelzverfahren ermöglicht deutlich höhere Raten und bessere Qualitäten.

Der Erfindung liegt die Aufgabe zugrunde, hochtemperatursupraleitenden Körper mit sehr guten, reproduzierbaren elektrischen und magnetischen Eigenschaften zu entwickeln. Eingeschlossen in diese Aufgabe ist die Entwicklung eines dementsprechenden Herstellungsverfahrens.

Diese Aufgabe wird mit den in den Patentansprüchen angegebenen Merkmalen gelöst.

Die Erfindung basiert auf einem hochtemperatursupraleitenden Körper, der die supraleitende Verbindung vom Typ $REMe_2Cu_3O_7$ enthält oder aus dieser besteht und der mit einem Schmelztexturierungsprozess hergestellt ist, wobei RE das chemische Element Y oder eines der chemischen Elemente mit der PSE-Ordnungszahl 57 bis 71 oder eine Mischung der genannten Elemente ist.

Erfindungsgemäß enthält der Körper zusätzlich eines oder mehrere der chemischen Elemente aus einer mit Ru, Ir, Rh, Hf, Ta und W gebildeten Gruppe A und zusätzlich eines oder mehrere der chemischen Elemente aus einer mit Zn, Li, Ni und Pd gebildeten Gruppe B. Dabei ist die molare Menge n des Zusatzes der Gruppe A je 1 Mol $REMe_2Cu_3O_7$ mit $0{,}01 < n < 0{,}3$ und die molare Menge m des Zusatzes der Gruppe B je 1 Mol $REMe_2Cu_3O_7$ mit $0{,}001 < m < 0{,}1$ gewählt. Gemäß einem weiteren Erfindungsmerkmal besteht der schmelztexturierte Körper aus einer supraleitenden Matrix, in der neben einem oder mehreren Elementen der Gruppe B Bereiche enthalten sind, die eines oder mehrere Elemente der Gruppe A konzentriert enthalten, wobei diese Bereiche als elongierte Partikel, als granulare Einschlüsse oder als lamellenartig ausgebildete Zonen vorliegen.

Die elongierten Partikel bestehen gemäß einer vorteilhaften Ausgestaltung der Erfindung aus $M_r Pt_p Al_a Ba_b Cu_c Y_y O_x$, wobei M mindestens eines der Elemente Ru, Ir, Rh, Hf, Ta und W ist und wobei gilt:

$$0,01 < r < 0,2$$

$$0 < p < 0,3$$

$$0 < a < 0,15$$

$$0,3 < b < 0,55$$

$$0,01 < c < 0,5$$

$$0 < y < 0,25.$$

Gemäß einer zweckmäßigen Ausgestaltung der Erfindung kann der supraleitende Körper als supraleitender Film mit einer Dicke im Bereich von 0,1 µm bis 100 µm ausgeführt sein.

RE kann das chemische Element Y oder eine Mischung verschiedener Seltenerdmetalle sein.

Das Ba kann ganz oder teilweise durch ein oder mehrere Elemente der Seltenerden und/oder der Erdalkalimetalle substituiert sein.

RE kann teilweise durch Ca gemäß $RE_{1-z} Ca_z Ba_2 Cu_3 O_7$- substituiert sein, wobei $0,01 < z < 0,2$ gilt.

Der Anteil des Pt in den elongierten Partikeln kann ganz oder teilweise durch eines oder mehrere der Elemente Ru, Ir, Rh, Hf, Ta, Rh, Ru, Ir und Rh ersetzt sein.

Das zur Herstellung solcher Bauteile entwickelte Verfahren ist dadurch gekennzeichnet, dass der Ausgangsmischung für den Schmelztexturierungsprozess ein Zusatz zugegeben wird, der eines oder mehrere der chemischen Elemente aus einer mit Ru, Ir, Rh, Hf, Ta und W gebildeten Gruppe A und eines oder mehrere der chemischen Elemente aus einer mit Zn, Li, Ni und Pd gebildeten Gruppe B enthält. Dabei wird die molare Menge n des Zusatzes der Gruppe A je 1 Mol $REMe_2 Cu_3 O_7$ mit $0,01 < n < 0,3$ und die molare Menge m des Zusatzes der Gruppe B je 1 Mol $REMe_2 Cu_3 O_7$ mit $0,001 < m < 0,1$ gewählt.

Die molare Menge n eines Ru-Zusatzes wird vorteilhafterweise mit $0,01 < n < 0,3$ je 1 Mol $REMe_2 Cu_3 O_7$ gewählt.

Die molare Menge m eines Zn-Zusatzes wird vorteilhafterweise mit $0,001 < m < 0,1$ je 1 Mol $REMe_2 Cu_3 O_7$ gewählt.

Die molare Menge k eines Li-Zusatzes wird vorteilhaft mit $0,001 < k < 0,1$ je 1 Mol $REMe_2 Cu_3 O_7$ gewählt.

Die erfindungsgemäßen hochtemperatursupraleitenden Körper weisen sehr gute reproduzierbare elektrische und magnetische Eigenschaften auf.

Der erfindungsgemäße Zusatz beeinflusst durch die chemischen Elemente Ru, Ir, Rh, Hf, Ta und/ oder W der Gruppe A in starkem Maße den Prozess der Schmelzkristallisation. Üblicherweise erfolgt die Schmelztexturierung mit einem Überschuss von $Y_2 BaCuO_5$, welches das Auseinanderfließen des partiell geschmolzenen Formkörpers verhindert. Der Überschuss findet sich dann als Fremdphase im Körper wieder. Die stabilisierende Funktion der Schmelze bei nur geringem Gehalt (entsprechende stöchiometrische Menge $Y_2 BaCuO_5$) übernehmen die Elemente der Gruppe A.

Bevorzugt soll der A-Gruppengehalt in der Mischung < 0,1 Mol je Mol RE123 betragen, wenn die Ausscheidung einer zweiten Phase nicht gewünscht wird. Dieser Fall ist dann angebracht, wenn die vorteilhaften starken Pinningkräfte, verursacht durch magnetische Momente im atomaren Bereich (nm-Skala), für die Flusshaftung ausgenutzt werden sollen.

Höhere A-Gruppengehalte sind dagegen vorteilhaft, wenn gleichzeitig durch Zugabe von Al und Pt die Bildung einer Phase $M_r Pt_p Al_a Ba_b Cu_c Y_y O_x$ angestrebt wird, wobei M eines der Elemente Ru, Ir, Rh, Hf, Ta und W ist. Diese Phase hat die Tendenz, feine nadelförmige Ausscheidungen in der supraleitenden Matrix zu bilden, die, ähnlich zu kolumnaren Strahlendefekten, Flusslinien mehrfach und fest pinnen.

Ein besonderer Vorteil besteht darin, dass hohe Stromdichten bei 77 K noch oberhalb 3 T erreicht werden.

Nachstehend ist die Erfindung an Ausführungsbeispielen näher erläutert.

<u>Beispiel 1</u>

Ein supraleitender Körper wird in einem Prozess aus folgenden wesentlichen Verfahrensschritten hergestellt:

a) Herstellung einer Pulvermischung und Formgebung (Pressen zu einem Formkörper oder Verstreichen auf einer Unterlage),

b) Durchführung eines Schmelzkristallisationsprozesses an dem geformten Körper,

c) Oxidation des kristallisierten Formkörpers.

Im Schritt a) wird zunächst ein Pulver der Aus-

gangsverbindung $YBa_2Cu_3O_7$ hergestellt aus einem Gemisch von $Y_2O_3$, $BaCO_3$ und CuO in entsprechenden molaren Anteilen durch dreimaliges Erhitzen auf 940 °C mit nachfolgender Zerkleinerung und Homogenisierung des Reaktionsproduktes. Dem so erhaltenen Pulver wird $RuO_2$-Pulver zugemischt im folgenden molaren Verhältnis:

$$1\ YBa_2Cu_3O_7 : 0,03\ RuO_2$$

Die erhaltene Pulvermischung wird zu einem zylindrischen Formkörper mit einem Durchmesser von 20 mm gepresst.

Zur Vorbereitung der Schmelztexturierung im Verfahrensschritt b) wird auf die Stirnfläche des Formkörpers mittig ein Keim aus einkristallinem $SmBa_2Cu_3O_7$ mit seiner kristallographischen c-Achse parallel zur Zylinderachse aufgesetzt. Bei der anschließenden Schmelztexturierung wird der Formkörper an Luft wie folgt wärmebehandelt:

1. Aufheizen mit 400 K/h auf 1050 °C
2. Schnelles Abkühlen auf 1020 °C
3. Kristallisation durch Abkühlen mit 1 K/h auf 975 °C

Im anschließenden Verfahrensschritt c) erfolgt die Oxidation des Formkörpers bei 380 °C über 150 Stunden in einer Sauerstoffatmosphäre.

Der so hergestellte Formkörper enthält eine supraleitende Matrix, die frei von Einschlüssen anderer Y-Ba-Cu-Oxide ist. In der Matrix sind lamellenartige Ru-haltige Zonen enthalten.

Beispiel 2

Das Beispiel betrifft einen aus einem supraleitenden Material bestehenden massiven Körper bei dem als supraleitende Matrix $YBa_2Cu_{2,99}Zn_{0,01}O_7$ frei von Einschlüssen der Phase $Y_2BaCuO_5$ oder anderer Y-Ba-Cu-O-Phasen entsteht. Zur Herstellung wird im Schritt a) ein Ausgangspulver aus $Y_2O_3$, $BaCO_3$, CuO und Zn in den der Formel entsprechenden Anteilen hergestellt.

Anschließend wird Ru-Pulver im Verhältnis

$$1\ Mol\ YBa_2Cu_{2,99}Zn_{0,01}O_7 : 0,03\ Mol\ RuO_2$$

zugemischt und die Mischung in analoger Weise wie in den Verfahrensschritten b) und c) des Beispiels 1 behandelt.

Der so hergestellte Formkörper enthält eine supraleitende Matrix, die frei von Einschlüssen anderer Y-Ba-Cu-Oxide ist. In der Matrix sind granulare Ru-haltige Einschlüsse enthalten.

Die kritische Stromdichte bei 77 K in einem so hergestellten Körper ist über einen weiten Bereich bis 3 T von einem außen angelegten Feld unabhängig und größer $5 \times 10^8$ $A/m^2$.

Beispiel 3

Dieses Beispiel betrifft die Herstellung eines supraleitenden massiven Körpers, bei dem die supraleitende Phase Li enthält, das einen Teil des Cu in der Verbindung $YBa_2Cu_3O_7$ ersetzt.

Die Herstellung erfolgt in analoger Weise wie in Beispiel 1 beschrieben, mit dem Unterschied, dass zur Herstellung des Ausgangspulvers $Y_2O_3$, $BaCO_3$, CuO und $Li_2CO_3$ in Anteilen gemischt werden, die der Formel $YBa_2Cu_{2,99}Li_{0,01}O_7$ entsprechen.

Der so hergestellte Formkörper enthält eine supraleitende Matrix, die frei von Einschlüssen anderer Y-Ba-Cu-Oxide ist. In der Matrix sind granulare Ru-haltige Einschlüsse enthalten.

Der erhaltene Körper zeichnet sich dadurch aus, dass bei 77 K die kritische Stromdichte im Bereich bis 3 T größer als $5 \times 10^8$ $A/m^2$ ist.

Beispiel 4

Das Beispiel betrifft den Fall, dass der supraleitende Körper in Form eines 50 m dicken Films auf einer Unterlage von $ZrO_2$ hergestellt wird. Dazu wird in Schritt a) ein Pulver der Zusammensetzung $YBa_2Cu_{2,985}Zn_{0,015}O_7$ hergestellt, dem $RuO_2$ im molarem Verhältnis

$$1\ YBa_2\ (Cu,\ Zn)_3O_7 : 0,\ 03\ RuO_2$$

zugemischt wird.

Das Gemisch wird in Ethanol aufgeschlämmt und in einer Kugelmühle 20 Minuten gemahlen. Nach der Separation des Mahlguts wird so viel Ethanol entzogen, bis eine verstreichbare Konsistenz erreicht ist. Der Schlicker wird mit einem Spatel auf eine Unterlage aus $ZrO_2$ als etwa 50 m dicker Film aufgetragen.

Nach dem Trocknen in Luft wird die beschichtete Unterlage in einen Zweizonenofen auf eine Temperatur von 1015 °C aufgeheizt. Nach Halten der Temperatur für 5 Minuten wird auf 1045 °C abgekühlt und mit zeitlicher Versetzung von 6 h ein langsamer Abkühlvorgang mit 0,5 K/h begonnen. Zwischen den beiden Ofenheizzonen wird dabei eine Temperaturdifferenz von 3 K eingestellt und die Temperatur kontinuierlich mit 0,5 K/h bis auf 975 °C weiter abgesenkt.

Abschließend wird die Oxidation bei 380 °C über 10 h analog wie im Beispiel 1 beschrieben durchgeführt.

Die erhaltene Schicht besteht aus einer supraleitenden Matrix, die vereinzelte Ru-haltige granulare Einschlüsse enthält.

Beispiel 5

Die Herstellung eines supraleitenden Körpers mit nadelförmigen Ausscheidungen wird im folgenden Ausführungsbeispiel beschrieben.

Zunächst wird ein Pulver der Zusammensetzung $YBa_2Cu_3O_7$ hergestellt aus den äquivalenten Mengen $Y_2O_3 + 2BaCuO_3 + 3\ CuO$, wie im Beispiel 1 beschrieben, dem nach Zerkleinerung $RuO_2$, $Y_2O_3$ und Pt-Pulver in den molaren Verhältnissen

$$1\ YBa_2Cu_3O_7 : 0{,}24\ Y_2O_3 : 0{,}035\ RuO_2 : 0{,}015\ Pt$$

zugemischt werden.

Nach dem Homogenisieren wird die Pulvermischung zu einem Formkörper der Abmessungen 35 35 20 mm² gepreßt. Zur Vorbereitung der Schmelzkristallisation wird der Körper mit einer quadratischen Seite auf eine keramische Platte aus $Al_2O_3$ gesetzt und auf der gegenüberliegenden freien Seite wird mittig ein Keimkristall aus $YBa_2Cu_3O_7$ plaziert. Anschließend wird im Verfahrensschritt b) der Schmelztexturierungsvorgang wie im Beispiel 1 beschrieben durchgeführt.

Es entsteht ein Formkörper, der eine supraleitende Matrix aus $YBa_2Cu_3O_7$ enthält, welche frei von Einschlüssen anderer Y-Ba-Cu-Oxide ist. In der Matrix ist neben granularen Einschlüssen von $Y_2BaCuO_5$ ein hoher Anteil elongierter Partikel in Form feiner Nadeln enthalten, die aus $Al_{0,12}Ba_{0,42}Cu_{0,09}Pt_{0,09}Ru_{0,07}Y_{0,21}O_{1,22}$ bestehen.

Der Körper zeichnet sich durch kritische Stromdichten über $5\ 10^8\ A/m^2$ in Feldern bis zu 3,5 T bei 77 K aus.

Beispiel 6

Ein supraleitender Körper wird in einem Prozess aus folgenden wesentlichen Verfahrensschritten hergestellt:

    a) Herstellung einer Pulvermischung und Formgebung (Pressen zu einem Formkörper oder Verstreichen auf einer Unterlage),

    b) Durchführung eines Schmelzkristallisationsprozesses an dem geformten Körper,

    c) Oxidation des kristallisierten Formkörpers.

Im Schritt a) wird zunächst ein Pulver der Ausgangsverbindung $YBa_2Cu_3O_7$ hergestellt aus einem Gemisch von $Y_2O_3$, $BaCO_3$ und CuO in entsprechenden molaren Anteilen durch dreimaliges Erhitzen auf 940 °C mit nachfolgender Zerkleinerung und Homogenisierung des Reaktionsproduktes. Dem so erhaltenen Pulver wird $HfO_2$-Pulver zugemischt im folgenden molaren Verhältnis:

$$1\ YBa_2Cu_3O_7 : 0{,}03\ HfO_2$$

Die erhaltene Pulvermischung wird zu einem zylindrischen Formkörper mit einem Durchmesser von 20 mm gepresst.

Zur Vorbereitung der Schmelztexturierung im Verfahrensschritt b) wird auf die Stirnfläche des Formkörpers mittig ein Keim aus einkristallinem $SmBa_2Cu_3O_7$ mit seiner kristallographischen c-Achse parallel zur Zylinderachse aufgesetzt. Bei der anschließenden Schmelztexturierung wird der Formkörper an Luft wie folgt wärmebehandelt:

    1. Aufheizen mit 400 K/h auf 1050 °C
    2. Schnelles Abkühlen auf 1020 °C
    3. Kristallisation durch Abkühlen mit 1 K/h auf 975 °C

Im anschließenden Verfahrensschritt c) erfolgt die Oxidation des Formkörpers bei 380 °C über 150 Stunden in einer Sauerstoffatmosphäre.

Der so hergestellte Formkörper enthält eine supraleitende Matrix, die frei von Einschlüssen anderer Y-Ba-Cu-Oxide ist. In der Matrix sind lamellenartige Hf-haltige Zonen enthalten.

Beispiel 7

Das Beispiel betrifft einen aus einem supraleitenden Material bestehenden massiven Körper bei dem als supraleitende Matrix $YBa_2Cu_{2,99}Zn_{0,01}O_7$ frei von Einschlüssen der Phase $Y_2BaCuO_5$ oder anderer Y-Ba-Cu-O-Phasen entsteht. Zur Herstellung wird im Schritt a) ein Ausgangspulver aus $Y_2O_3$, $BaCO_3$, CuO und Zn in den der Formel entsprechenden Anteilen hergestellt.

Anschließend wird $Ta_2O_5$-Pulver im Verhältnis

$$1\ Mol\ YBa_2Cu_{2,99}Zn_{0,1}O_7 : 0{,}15\ Mol\ Ta_2O_5$$

zugemischt und die Mischung in analoger Weise wie in den Verfahrensschritten b) und c) des Beispiels 1 behandelt.

Der so hergestellte Formkörper enthält eine supraleitende Matrix, die frei von Einschlüssen anderer Y-Ba-Cu-Oxide ist. In der Matrix sind granulare Ta-haltige Einschlüsse enthalten.

Die kritische Stromdichte bei 77 K in einem so hergestellten Körper ist über einen weiten Bereich bis 3 T von einem außen angelegten Feld unabhängig und größer $5 \times 10^8\ A/m^2$.

Beispiel 8

Dieses Beispiel betrifft den Fall, dass der supraleitende Körper in Form eines 50 m dicken Films auf

einer Unterlage von $MgO_2$ hergestellt wird. Dazu wird in Schritt a) ein Pulver der Zusammensetzung $YBa_2Cu_{2,985}Zn_{0,015}O_7$ hergestellt, dem $HfO_2$ im molarem Verhältnis

$$1 \ YBa_2 \ (Cu, Zn)_3O_7 : 0,03 \ HfO_2$$

zugemischt wird.

Das Gemisch wird in Ethanol aufgeschlämmt und in einer Kugelmühle 20 Minuten gemahlen. Nach der Separation des Mahlguts wird so viel Ethanol entzogen, bis eine verstreichbare Konsistenz erreicht ist. Der Schlicker wird mit einem Spatel auf eine Unterlage aus $ZrO_2$ als etwa 50 m dicker Film aufgetragen.

Nach dem Trocknen in Luft wird die beschichtete Unterlage in einen Zweizonenofen auf eine Temperatur von 1015 °C aufgeheizt. Nach Halten der Temperatur für 5 Minuten wird auf 1045 °C abgekühlt und mit zeitlicher Versetzung von 6 h ein langsamer Abkühlvorgang mit 0,5 K/h begonnen. Zwischen den beiden Ofenheizzonen wird dabei eine Temperaturdifferenz von 3 K eingestellt und die Temperatur kontinuierlich mit 0,5 K/h bis auf 975 °C weiter abgesenkt.

Abschließend wird die Oxidation bei 380 °C über 100 h analog wie im Beispiel 1 beschrieben durchgeführt.

Die erhaltene Schicht besteht aus einer supraleitenden Matrix, die vereinzelte Ru-haltige granulare Einschlüsse enthält.

Beispiel 9

Die Herstellung eines supraleitenden Körpers mit nadelförmigen Ausscheidungen wird im folgenden Ausführungsbeispiel beschrieben.

Zunächst wird ein Pulver der Zusammensetzung $YBa_2Cu_3O_7$ hergestellt aus den äquivalenten Mengen $Y_2O_3 + 2BaCuO_3 + 3 \ CuO$, wie im Beispiel 1 beschrieben, dem nach Zerkleinerung $Ta_2O_5$, $Y_2O_3$ und Pt-Pulver in den molaren Verhältnissen

$$1 \ YBa_2Cu_3O_7 : 0,24 \ Y_2O_3 : 0,017 \ Ta_2O_5 : 0,015 \ Pt$$

zugemischt werden.

Nach dem Homogenisieren wird die Pulvermischung zu einem Formkörper der Abmessungen 35 35 20 mm² gepreßt. Zur Vorbereitung der Schmelzkristallisation wird der Körper mit einer quadratischen Seite auf eine keramische Platte aus $Al_2O_3$ gesetzt und auf der gegenüberliegenden freien Seite wird mittig ein Keimkristall aus $YBa_2Cu_3O_7$ plaziert. Anschließend wird im Verfahrensschritt b) der Schmelztexturierungsvorgang wie im Beispiel 1 beschrieben durchgeführt.

Es entsteht ein Formkörper, der eine supraleitende Matrix aus $YBa_2Cu_3O_7$ enthält, welche frei von Einschlüssen anderer Y-Ba-Cu-Oxide ist. In der Matrix ist neben granularen Einschlüssen von $Y_2BaCuO_5$ ein hoher Anteil elongierter Partikel in Form feiner Nadeln enthalten, die aus $Al_{0,12}Ba_{0,42}Cu_{0,09}Pt_{0,09}Ta_{0,07}Y_{0,21}O_{1,22}$ bestehen.

Der Körper zeichnet sich durch kritische Stromdichten über $5 \ 10^8 \ A/m^2$ in Feldern bis zu 3,5 T bei 77 K aus.

**Patentansprüche**

1. Hochtemperatursupraleitender Körper, enthaltend die supraleitende Verbindung vom Typ $REMe_2Cu_3O_7$ oder bestehend aus dieser, hergestellt mit einem Schmelztexturierungsprozess, wobei RE das chemische Element Y oder eines der chemischen Elemente mit der PSE-Ordnungszahl 57 bis 71 oder eine Mischung der genannten Elemente ist, **dadurch gekennzeichnet, dass** der Körper zusätzlich eines oder mehrere der chemischen Elemente aus einer mit Ru, Ir, Rh, Hf, Ta und W gebildeten Gruppe A und zusätzlich eines oder mehrere der chemischen Elemente aus einer mit Zn, Li, Ni und Pd gebildeten Gruppe B enthält, wobei die molare Menge n des Zusatzes der Gruppe A je 1 Mol $REMe_2Cu_3O_7$ mit $0,01 < n < 0,3$ und die molare Menge m des Zusatzes der Gruppe B je 1 Mol $REMe_2Cu_3O_7$ mit $0,001 < m < 0,1$ gewählt ist, und dass der schmelztexturierte Körper aus einer supraleitenden Matrix besteht, in der neben einem oder mehreren Elementen der Gruppe B Bereiche enthalten sind, die eines oder mehrere Elemente der Gruppe A konzentriert enthalten, wobei diese Bereiche als elongierte Partikel, als granulare Einschlüsse oder als lamellenartig ausgebildete Zonen vorliegen.

2. Hochtemperatursupraleitender Körper nach Anspruch 1, **dadurch gekennzeichnet, dass** die elongierten Partikel aus $M_rPt_pAl_aBa_bCu_cY_yO_x$ bestehen, wobei M mindestens eines der Elemente Ru, Ir, Rh, Hf, Ta und W ist und wobei gilt:

$$0,01 < r < 0,2$$

$$0 < p < 0,3$$

$$0 < a < 0,15$$

$$0,3 < b < 0,55$$

$$0,01 < c < 0,5$$

$$0 < y < 0,25.$$

3. Hochtemperatursupraleitender Körper nach Anspruch 1, **dadurch gekennzeichnet, dass** der Körper ein supraleitender Film mit einer Dicke im Bereich von 0,1 μm bis 100 μm ist.

4. Hochtemperatursupraleitender Körper nach Anspruch 1, **dadurch gekennzeichnet, dass** RE das chemische Element Y oder eine Mischung verschiedener Seltenerdmetalle ist.

5. Hochtemperatursupraleitender Körper nach Anspruch 2, **dadurch gekennzeichnet, dass** das Ba ganz oder teilweise durch ein oder mehrere Elemente der Seltenerden und/oder der Erdalkalimetalle substituiert ist.

6. Hochtemperatursupraleitender Körper nach Anspruch 1, **dadurch gekennzeichnet, dass** RE teilweise durch Ca gemäß $RE_{1-z}Ca_zBa_2Cu_3O_7$- substituiert ist, wobei $0,01 < z < 0,2$ gilt.

7. Hochtemperatursupraleitender Körper nach Anspruch 2, **dadurch gekennzeichnet, dass** der Anteil des Pt ganz oder teilweise durch eines oder mehrere der Elemente Ru, Ir, Rh, Hf, Ta, und W ersetzt ist.

8. Verfahren zur Herstellung hochtexturierter oder einkristalliner hochtemperatursupraleitender Körper durch einen Schmelzkristallisationsprozess, bei dem als supraleitende Phase eine Verbindung vom Typ $REMe_2Cu_3O_7$ entsteht, wobei RE das chemische Element Y oder eines der chemischen Elemente mit der PSE-Ordnungszahl 57 bis 71 oder eine Mischung der genannten Elemente ist, nach einem der Ansprüche 1 bis 7, **dadurch gekennzeichnet, dass** der Ausgangsmischung für den Schmelztexturierungsprozess ein Zusatz zugegeben wird, der eines oder mehrere der chemischen Elemente aus einer mit Ru, Ir, Rh, Hf, Ta und W gebildeten Gruppe A und eines oder mehrere der chemischen Elemente aus einer mit Zn, Li, Ni und Pd gebildeten Gruppe B enthält, wobei die molare Menge n des Zusatzes der Gruppe A je 1 Mol $REMe_2Cu_3O_7$ mit $0,01 < n < 0,3$ und die molare Menge m des Zusatzes der Gruppe B je 1 Mol $REMe_2Cu_3O_7$ mit $0,001 < m < 0,1$ gewählt wird.

9. Verfahren nach Anspruch 8, **dadurch gekennzeichnet, dass** die molare Menge n eines Ru-Zusatzes je 1 Mol $REMe_2Cu_3O_7$ mit $0,01 < n < 0,3$ gewählt wird.

10. Verfahren nach Anspruch 8, **dadurch gekennzeichnet, dass** die molare Menge m eines Zn-Zusatzes je 1 Mol $REMe_2Cu_3O_7$ mit $0,001 < m < 0,1$ und die molare Menge k eines Li-Zusatzes je 1 Mol $REMe_2Cu_3O_7$ mit $0,001 < k < 0,1$ gewählt werden.